# EUROPÄISCHE PATENTSCHRIFT

(11) **EP 3 028 550 B1**
(45) Veröffentlichungstag und Bekanntmachung des Hinweises auf die Patenterteilung: **15.01.2020**
(21) Anmeldenummer: 14733604.4
(22) Anmeldetag: 24.06.2014
(51) Int. Cl.: H05K 5/00

(54) **STEUERGERÄT UND ANORDNUNG MIT EINEM STEUERGERÄT**
CONTROL DEVICE AND ASSEMBLY HAVING A CONTROL DEVICE
CONTRÔLEUR ET ARRANGEMENT ÉQUIPÉ D'UN CONTRÔLEUR

(30) Priorität: 29.07.2013 DE 102013214714
(43) Veröffentlichungstag der Anmeldung: 08.06.2016
(73) Patentinhaber: Robert Bosch GmbH, 70442 Stuttgart (DE)
(72) Erfinder: LISCHECK, Andre, 71665 Vaihingen/Enz (DE); KROECKEL, Markus, 71701 Schwieberdingen (DE); GEBERS, Joerg, 71282 Hemmingen (DE)
(86) Internationale Anmeldenummer: PCT/EP2014/063234
(87) Internationale Veröffentlichungsnummer: WO 2015/014541

(56) Entgegenhaltungen:
- EP-A1- 1 672 972
- DE-A1-102010 002 947
- DE-A1-102010 002 950
- DE-A1-102011 005 858
- DE-A1-102011 084 727

## Beschreibung

### Stand der Technik

Die Erfindung betrifft ein Steuergerät nach dem Oberbegriff des Anspruchs 1. Ferner betrifft die Erfindung eine Anordnung, umfassend ein erfindungsgemäßes Steuergerät und eine mit dem Steuergerät verbindbare elektrische Baueinheit sowie die Verwendung der Anordnung.

Ein Steuergerät nach dem Oberbegriff des Anspruchs 1 ist aus der DE 10 2010 002 947 A1 der Anmelderin bekannt. Es umfasst einen Schaltungsträger, z.B. in Form einer Leiterplatte oder Ähnlichem, auf dem wenigstens eine Schaltungseinheit angeordnet ist, die über mit der Schaltungseinheit zumindest mittelbar verbundene Kontakteinheiten mit einer anderen elektrischen Baueinheit (beispielsweise einem Kabelbaum eines Kraftfahrzeugs) elektrisch kontaktierbar ist. Wesentlich dabei ist, dass der Schaltungsträger, zumindest mit Ausnahme der Bereiche, in denen die Kontakteinheiten mit der anderen elektrischen Baueinheit verbindbar sind, von einer Schutzmasse umgeben ist. Die Schutzmasse, die insbesondere aus Kunststoff besteht und nach Vergießen des Schaltungsträgers oder Umspritzen mit einem duroplastischen Kunststoff (zum Beispiel im sogenannten "Thermotransfer-Moulding-Verfahren") aushärtet, bildet eine Gehäuseeinheit aus. In der oben genannten Schrift sind verschiedene Möglichkeiten zur elektrischen Kontaktierung der Kontakteinheiten des Steuergeräts mittels unterschiedlich ausgebildeter elektrischer Baueinheiten dargestellt bzw. offenbart. Zum Einsatz kommen dabei insbesondere als Federelemente ausgebildete Gegenelemente, die unter Ausbildung einer Vorspannkraft an den Kontakteinheiten anliegen. Wesentlich dabei ist, dass das Erzeugen der Vorspannkräfte auf die Federelemente allein durch eine entsprechende Ausbildung der anderen elektrischen Baueinheit erfolgt, d.h., dass das Steuergerät bzw. dessen Gehäuseeinheit diesbezüglich keine zusätzlichen Maßnahmen oder Elemente aufweist. Nachteilhaft dabei ist, dass durch das Erfordernis, dass die Kontakteinheiten frei von der Schutzmasse sind, diese vor der Kontaktierung mit der anderen elektrischen Baueinheit ungeschützt angeordnet sind. Dadurch besteht die Gefahr, dass beispielsweise Fremdkörper oder Ähnliches in den Bereich der Kontakteinheiten geraten oder diese auf sonstige Art und Weise mechanisch beschädigt werden, ohne dass dies erkannt wird. Weiterhin erfordert eine derartige Ausbildung des Steuergeräts, bei der die gesamte Funktionalität der Kontaktierung, insbesondere das Aufbringen der erforderlichen Vorspannkraft auf die Gegenelemente, in der anderen elektrischen Baueinheit realisiert ist, eine relativ aufwändig gestaltete Baueinheit, zum Beispiel einen aufwendigen Kabelbaumanschluss.

Die Offenlegungsschrift DE102011084727 A1 zeigt ein ummoldetes Steuergerät mit einem verbundenen Steckergehäuse. Innerhalb des Steckergehäuses ist eine Kontaktelementenaufnahmekammer zur Aufnahme wenigstens eines elektrischen Kontaktelementes ausgebildet. In einer gesteckten Endposition kontaktiert das Kontaktelement einen elektrisch leitfähigen Teilbereich des Steuergerätes. Zusätzlich ist das Kontaktelement in der Endposition mit einem Verrastungselement unlösbar verrastet, welches innerhalb der Kontaktelementenaufnahmekammer angeordnet ist.

Die Offenlegungsschrift DE102011005858 A1 offenbart ein Direktsteckelement umfassend einen inneren Schieber, über welchen in unterschiedlichen Lagepositionen jeweils unterschiedliche Vorspannkräfte auf Kontaktelemente des Direktsteckelementes erzeugt werden.

### Offenbarung der Erfindung

Ausgehend von dem dargestellten Stand der Technik liegt der Erfindung die Aufgabe zugrunde, ein Steuergerät nach dem Oberbegriff des Anspruchs 1 derart weiterzubilden, dass dieses einen Teil der Funktionalität hinsichtlich der elektrischen Kontaktierung durch eine elektrische Baueinheit übernimmt. Diese Aufgabe wird erfindungsgemäß bei einem Steuergerät mit den Merkmalen des Anspruchs 1 dadurch gelöst, dass mit der Gehäuseeinheit des Steuergeräts wenigstens ein Anpresselement verbunden ist, das dazu ausgebildet ist, zumindest mittelbar eine Kontaktkraft auf ein die Kontakteinheit elektrisch kontaktierendes Gegenelement der anderen elektrischen Baueinheit zu erzeugen.

Vorteilhafte Weiterbildungen des erfindungsgemäßen Steuergeräts sind in den Unteransprüchen angegeben.

In bevorzugter konstruktiver Umsetzung des Vorschlags ist es vorgesehen, dass das wenigstens eine Anpresselement in einem mit der Gehäuseeinheit verbundenen Anbauelement angeordnet ist. Mit anderen Worten gesagt bedeutet dies, dass das Anbauelement und die Gehäuseeinheit separate Bauteile darstellen, wodurch die Möglichkeit geschaffen wird, diese jeweils für sich zu optimieren. Insbesondere wird dadurch die Möglichkeit geschaffen, das Anbauelement aus einem anderen Material auszubilden als die Gehäuseeinheit.

In ganz besonders bevorzugter Ausgestaltung des Anbauelements ist es vorgesehen, dass das Anbauelement den Schaltungsträger zumindest im Bereich der Kontakteinheit umgibt. Dadurch ist ein gegenüber dem Stand der Technik deutlich erhöhter Schutz der Kontakteinheit vor direkten Eingriffen an den Kontakteinheiten gegeben, die ggf. zu einer Beschädigung oder einer Vorschädigung der Kontakteinheiten führen könnten.

In konstruktiver Umsetzung ist es vorgesehen, dass das Anbauelement aus Kunststoff besteht und im Wesentlichen eine hülsenförmige Form aufweist, die auf der der Gehäuseeinheit abgewandten Stirnseite eine Öffnung zum Einführen des Gegenelements der anderen elektrischen Baueinheit hat. Mit anderen Worten gesagt bedeutet dies, dass das Anbauelement die Kontakteinheit kragenförmig umschließt und stirnseitig eine Öffnung aufweist, in der das Gegenelement einführbar und in Wirkverbindung mit der Kontakteinheit gebracht werden kann.

Um eine besonders einfache Montage des Anbauelements an der Gehäuseeinheit, insbesondere ohne Verwendung zusätzlicher Befestigungsteile bzw. Befestigungselemente wie Befestigungsschrauben oder Ähnlichem zu ermöglichen, ist es darüber hinaus bevorzugt vorgesehen, dass das Anbauelement mit der Gehäuseeinheit mittels einer Rastverbindung verbunden ist.

Zur Erzeugung der erforderlichen Kontaktkräfte auf das Gegenelement ist es bevorzugt vorgesehen, dass das Anpresselement als ein aus Metall bestehendes Federelement ausgebildet ist, das vorzugsweise durch eine kraftschlüssige Verbindung mit dem Anbauelement verbunden ist. Unter einer kraftschlüssigen Verbindung wird dabei im Rahmen der Erfindung beispielsweise eine widerhakenähnliche Kontur an einem Teilabschnitt des Federelements verstanden, sodass das Federelement in eine entsprechende Ausnehmung des Anbauelements eingepresst werden kann und dort durch Verkrallen hält. Somit sind keine zusätzlichen Befestigungselemente erforderlich.

In bevorzugter Ausgestaltung des Federelements ist es vorgesehen, dass dieses mehrere Federabschnitte aufweist, wobei die Federabschnitte mittels eines Verbindungsabschnitts miteinander verbunden sind, und wobei der Verbindungsabschnitt einen umgebogenen Versteifungsabschnitt aufweist, der in Richtung zu den Federabschnitten umgebogen ist. Dadurch wird trotz der Verwendung ggf. relativ geringer Blechquerschnitte ein sehr steifes Federelement erzielt.

Insbesondere weist der Federabschnitt einen Anlagebereich auf, der dazu ausgebildet ist, mit dem Gegenelement der anderen elektrischen Baueinheit zumindest mittelbar zusammenzuwirken, wobei der Anlagebereich in Überdeckung und beabstandet zur Kontakteinheit angeordnet ist. Eine derartige Ausbildung ermöglicht es, die Kontakteinheit selbst innerhalb des Anbauelements nochmals zusätzlich vor äußeren Manipulationen bzw. Eingriffen zu schützen.

Um zu vermeiden, dass durch Eintritt von Medien, wie Feuchtigkeit oder Ähnlichem, die elektrische Verbindung zwischen dem Steuergerät und der anderen elektrischen Baueinheit beeinträchtigt wird, ist es weiterhin in bevorzugter Ausgestaltung der Erfindung vorgesehen, dass zwischen dem Anbauelement und der Gehäuseeinheit wenigstens ein Dichtungselement angeordnet ist.

Die Erfindung umfasst auch eine Anordnung, bestehend aus einem erfindungsgemäßen Steuergerät und einer elektrischen Baueinheit, die dazu ausgebildet ist, mit dem Steuergerät verbunden zu werden. Erfindungsgemäß ist es vorgesehen, dass die elektrische Baueinheit wenigstens einen vorzugsweise plattenförmigen Kontaktträger aufweist, der für jede Kontakteinheit ein Gegenelement aufweist.

In konstruktiv bevorzugter Ausgestaltung des Kontaktträgers ist dieser in der Baueinheit elastisch verformbar angeordnet und von dem Andrückelement auf der dem Gegenelement abgewandten Seite, die Andrückkraft auf das Gegenelement bildend, in Richtung zur Kontakteinheit bewegbar.

In weiterer Ausgestaltung der elektrischen Baueinheit ist es vorgesehen, dass der Kontaktträger, vorzugsweise unter Zwischenlage eines Dichtelements, mit einem Halteelement verbunden ist, wobei das Halteelement dazu ausgebildet ist, mit dem Steuergerät verbunden zu werden.

Um es einerseits zu ermöglichen, dass die andere elektrische Baueinheit in Wirkverbindung mit dem Anbauelement des Steuergeräts gebracht werden kann und andererseits eine mechanisch einfache und wirkungsvolle Verbindung mit dem Steuergerät herzustellen, ist es darüber hinaus vorgesehen, dass der Kontaktträger auf der dem Steuergerät zugewandten Seite aus dem Halteelement herausragt, und dass das Halteelement einen Gehäuseabschnitt aufweist, der dazu ausgebildet ist, das Steuergerät zumindest mittelbar zu umfassen bzw. zu umgreifen.

Die elektrische Baueinheit ist insbesondere Bestandteil eines Kabelbaums bzw. ein Kabelbaumstecker, der dazu dient, das Steuergerät beispielsweise mit Sensoren, Aktoren oder sonstigen elektrischen bzw. elektronischen Komponenten, insbesondere eines Kraftfahrzeugs, zu kontaktieren.

Weitere Vorteile, Merkmale und Einzelheiten der Erfindung ergeben sich aus der nachfolgenden Beschreibung bevorzugter Ausführungsbeispiele sowie anhand der Zeichnung.

Diese zeigt in:
- Fig. 1: ein von einer Schutzmasse umgebenes Steuergerät gemäß dem Stand der Technik in perspektivischer Ansicht,
- Fig. 2: ein erfindungsgemäßes Steuergerät unter Verwendung eines Anbauelements mit daran befestigtem Kabelbaumstecker in perspektivischer Ansicht,
- Fig. 3: das Steuergerät gemäß Fig. 2 sowie einen Endbereich eines Kabelbaums mit einem Steckeranschluss, der mit dem Steuergerät verbunden werden kann, jeweils in Seitenansicht sowie in Draufsicht,
- Fig. 4: die wesentlichen Einzel- bzw. Bestandteile der Anordnung gemäß Fig. 3 in Einzeldarstellungen, ebenfalls in Draufsicht bzw. Seitenansicht,
- Fig. 5 und Fig. 6: den Kontaktierungsvorgang zwischen dem Steuergerät und dem Kabelbaumstecker während verschiedener Montagephasen, jeweils in vereinfacht dargestelltem Längsschnitt,
- Fig. 7: eine perspektivische Ansicht auf ein Federelement, wie es bei einem erfindungsgemäßen Steuergerät als Teil des Anbauelements verwendet wird ,
- Fig. 8: eine Seitenansicht auf das Federelement gemäß Fig. 7 und
- Fig. 9: ein Anbauelement in einer perspektivischen Einzeldarstellung.

Gleiche Elemente bzw. Elemente mit gleicher Funktion sind in den Figuren mit den gleichen Bezugsziffern versehen.

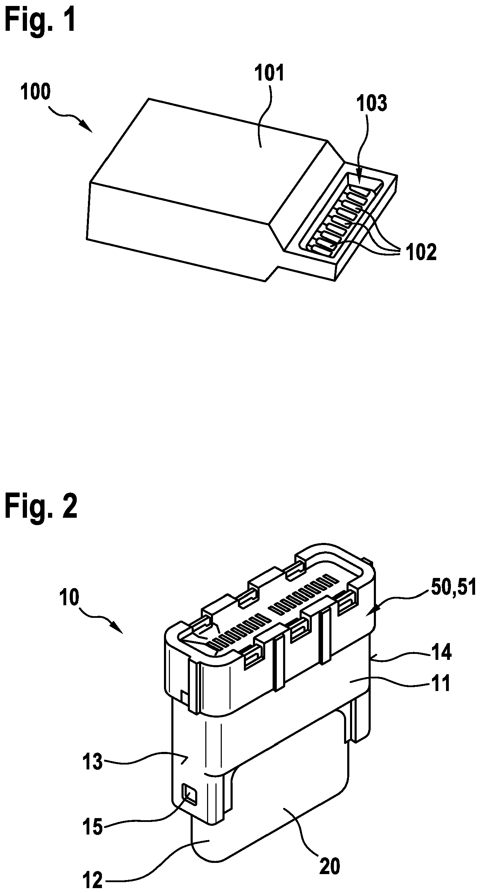

In der Fig. 1 ist ein Steuergerät 100 gemäß dem Stand der Technik dargestellt. Es umfasst einen nicht erkennbaren Schaltungsträger, z.B. in Form einer Leiterplatte oder Ähnlichem, mit wenigstens einer darauf angeordneten Schaltungseinheit. Der Schaltungsträger ist von einer aus Kunststoff bestehenden Schutzmasse umgeben, die eine Gehäuseeinheit 101 ausbildet. Bei der Schutzmasse kann es sich dabei beispielsweise um einen (harten) Kunststoff handeln, wobei der Schaltungsträger von dem Kunststoff umgossen ist, oder um einen duroplastischen Kunststoff, sodass das Steuergerät 100 als sogenanntes gemouldetes Steuergerät 100 ausgebildet ist. Der innerhalb der Gehäuseeinheit 101 angeordnete Schaltungsträger wird über mehrere, im Ausführungsbeispiel parallel zueinander angeordnete Kontakteinheiten 102 elektrisch kontaktiert, wobei die Gehäuseeinheit 101 im Bereich der Kontakteinheiten 102 eine Aussparung 103 aufweist, in deren Bereich die Gehäuseeinheit 101 frei von der Schutzmasse ist. Bei den Kontakteinheiten 102 handelt es sich insbesondere um elektrisch leitende Beschichtungen in Form sogenannter Lands.

In der Fig. 2 ist ein erfindungsgemäßes Steuergerät 10 dargestellt, das sich von dem Steuergerät 100 gemäß der Fig. 1 im Wesentlichen dadurch unterscheidet, dass das Steuergerät 10 ein Anbauelement 11 aufweist, das mit der Gehäuseeinheit 12 verbunden ist. Ansonsten besteht die Gehäuseeinheit 12 in Analogie zu dem Steuergerät 100 ebenfalls aus einer aus Kunststoff bestehenden Schutzmasse 20, die einen eine Schaltungseinheit tragenden Schaltungsträger (unmittelbar) umgibt bzw. diesen einschließt.

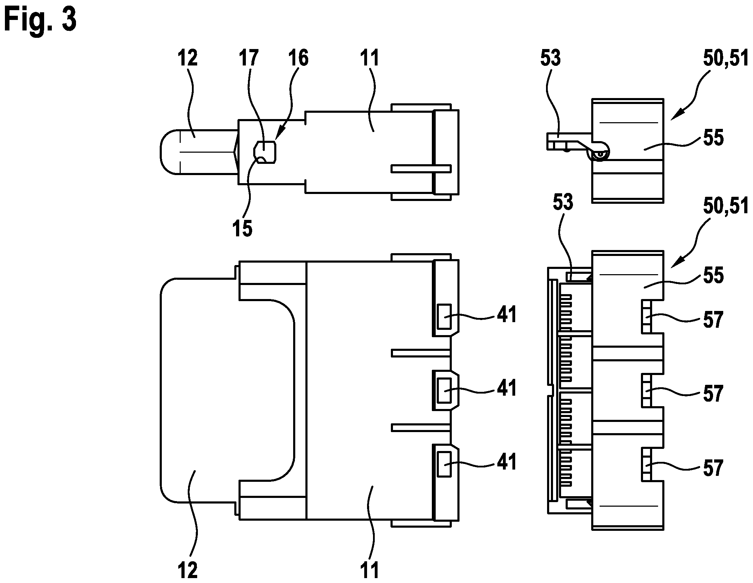

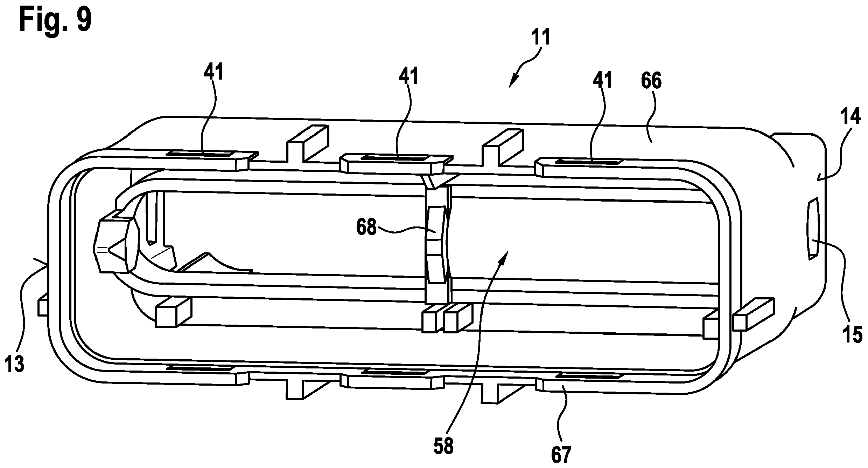

Das aus Kunststoff bestehende, als Spritzgußteil ausgebildete Anbauelement 11 ist in etwa kragen- bzw. hülsenförmig ausgebildet und weist im Bereich zweier gegenüberliegender Seitenflächen 13, 14 jeweils eine in etwa rechteckförmige Aussparung 15 auf, wobei in der Fig. 2 lediglich die eine Aussparung 15 an der Seitenfläche 13 erkennbar ist. Die Aussparung 15 ist Bestandteil einer Rastverbindung 16 zwischen der Gehäuseeinheit 12 und dem Anbauelement 11, wozu die Gehäuseeinheit 12 an den entsprechenden Seitenwänden Vorsprünge 17 aufweist, die bei an der Gehäuseeinheit 12 montiertem Anbauelement 11 mit den Aussparungen 15 unter Ausbildung der Rastverbindung 16 zusammenwirken (Fig. 3). Das Anbauelement 11 ist mit einer Baueinheit 50 in Form eines Kabelbausteckers 51 verbunden, der nachfolgend noch näher beschrieben wird. Wie anhand der Fig. 9 erkennbar ist, weist das Anbauelement 11 auf der dem Kabelbaustecker 51 zugewandten Seite zwischen einer oberen Wand 66 und einer unteren Wand 67 sowie den beiden Seitenflächen 13, 14 eine Öffnung 58 zum Einführen eines Teilbereichs des Kabelbaumsteckers 51 auf, wobei die beiden Wände 66, 67 in etwa in der Mitte der Öffnung 58 mittels eines der Versteifung dienenden Stegs 68 miteinander verbunden sind.

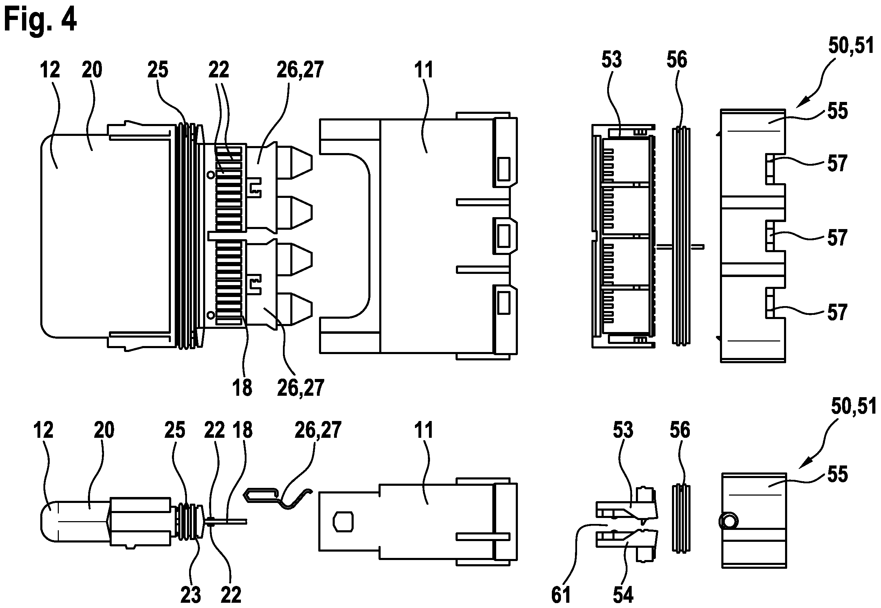

Wie insbesondere anhand der Fig. 4 bis 6 erkennbar ist, ragt aus der einen Stirnseite der Gehäuseeinheit 12 der als Leiterplatte 18 ausgebildete Schaltungsträger des Steuergeräts 10 heraus. Dabei ist die Leiterplatte 18 vorzugsweise in einer Symmetrieebene des Steuergeräts 10 angeordnet, wobei der aus der Gehäuseeinheit 12 herausragende Bereich der Leiterplatte 18 im Ausführungsbeispiel vollständig frei von der Schutzmasse 20 ist. Wenigstens an einer Seite der Leiterplatte 18, bevorzugt jedoch sowohl an der Oberseite als auch an der Unterseite der Leiterplatte 18, sind an dem aus der Gehäuseeinheit 12 herausragenden Bereich eine Vielzahl von parallel zueinander angeordneten, streifenförmigen Kontakteinheiten 22 angeordnet. Die Kontakteinheiten 22 sind zumindest mittelbar mit der innerhalb der Gehäuseeinheit 12 auf der Leiterplatte 18 angeordneten Schaltungseinheit elektrisch verbunden.

Um den Zutritt von Medien zu den Kontakteinheiten 22 bei mit der Gehäuseeinheit 12 verbundenem Anbauelement 11 zu verhindern, weist die Gehäuseeinheit 12 eine umlaufende, nutartige Ausnehmung 23 auf, in der ein Dichtungselement 25 angeordnet ist, das bei montiertem Anbauelement 11 in Wirkverbindung mit dem Anbauelement 11 angeordnet ist.

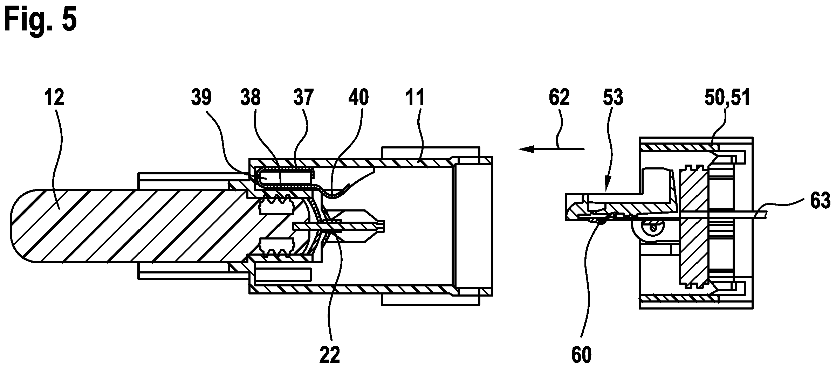

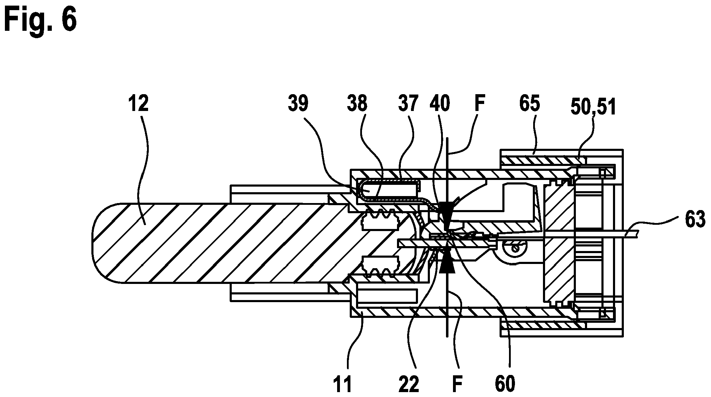

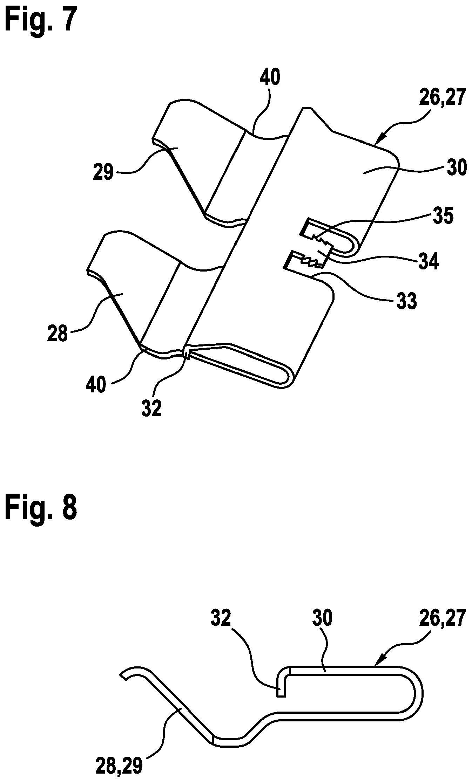

In dem Anbauelement 11 ist wenigstens ein in den Fig. 4, 7 und 8 besonders gut erkennbares Anpresselement 26 in Form eines aus Metall bestehenden Federelements 27 angeordnet. Das einstückig ausgebildete Federelement 27 weist zwei, parallel zueinander angeordnete und in Draufsicht gebogen ausgebildete Federabschnitte 28, 29 auf, die mittels eines Verbindungsabschnitts 30 miteinander verbunden sind. Der Verbindungsabschnitt 30 weist einen in etwa rechtwinklig zu den Federabschnitten 28, 29 umgebogenen Versteifungsabschnitt 32 auf. Weiterhin ist im Bereich des Verbindungsabschnitts 30 eine Aussparung 33 ausgebildet, in die ein Rastabschnitt 34 des Federelements 27 hineinragt. Der Rastabschnitt 34 weist beispielsweise eine widerhakenartige Kontur 35 auf, die dazu dient, beim Einführen in eine entsprechende Ausnehmung des Anbauelements 11 das Federelement 27 durch eine kraftschlüssige Verbindung mit dem Anbauelement 11 zu verbinden und zu sichern. Entsprechend der Darstellung der Fig. 5 und 6 sind die beiden parallel zueinander angeordneten Abschnitte 37, 38 des Federelements 27 in einem Hohlraum 39 des Anbauelements 11 formschlüssig aufgenommen. Weiterhin erkennt man, dass die beiden Federabschnitte 28, 29 jeweils einen Anlagebereich 40 aufweisen, der fluchtend zu den Kontakteinheiten 22 und mit Abstand zu diesen angeordnet ist.

Auf der der Gehäuseeinheit 12 abgewandten Seite des Anbauelements 11 weist dieses darüber hinaus an seiner Ober- bzw. Unterseite jeweils drei Rastzungen mit Öffnungen 41 auf, die dazu dienen, das Steuergerät 10 bzw. das Anbauelement 11 mit der elektrischen Baueinheit 50 in Form des Kabelbaumsteckers 51 zu verbinden.

Der Kabelbaumstecker 51 besteht im Wesentlichen aus drei, in der Fig. 4 erkennbaren Hauptbestandteilen. Zum einen sind zwei, im Wesentlichen plattenförmige Kontaktträger 53, 54 vorgesehen, die dazu ausgebildet sind, mit den auf der Oberseite bzw. Unterseite der Leiterplatte 18 angeordneten Kontakteinheiten 22 (zumindest mittelbar) elektrisch kontaktiert zu werden. Die beiden Kontaktträger 53, 54 sind bereichsweise in einem hülsenförmigen Halteelement 55 angeordnet, z.B. durch eine Rastverbindung oder Ähnliches. Weiterhin ist ein Dichtelement 56 vorgesehen, das den Zutritt von Medien in Richtung der Kontaktträger 53, 54 verhindert. Es wird erwähnt, dass in den Fig. 3, 5 und 6 der Einfachheit halber lediglich jeweils nur der eine Kontaktträger 53 dargestellt ist. Die Anordnung des anderen Kontaktträgers 54 ist aus der Fig. 4 entnehmbar. An dem Halteelement 55 sind Vorsprünge 57 ausgebildet, die als Teil der Rastverbindung dazu dienen, mit den Öffnungen 41 an dem Anbauelement 11 zusammenzuwirken. Dabei ist die Dimensionierung bzw. Geometrie des Halteelements 55 derart, dass dieses mit seinem Innenumfang des Gehäuseabschnitts 65 auf den Außenumfang des Anbauelements 11 aufgeschoben werden kann. Weiterhin ist die Anordnung der Kontaktträger 53, 54, die aus dem Halteelement 55 teilweise herausragen, derart, dass diese in die in der Fig. 9 erkennbare, stirnseitige Öffnung 58 des Anbauelements 11 eingeführt werden können. In den beiden Kontaktträgern 53, 54 ist für jede der Kontakteinheiten 22 des Steuergeräts 10 jeweils ein vorzugsweise als Federelement ausgebildetes Gegenelement 60 angeordnet (Fig. 5, 6), das wiederum auf der dem Steuergerät 10 abgewandten Seite des Kabelbaumsteckers 51 elektrisch mit einer Leitung 63 (Fig. 5, 6) verbunden ist.

Wesentlich ist auch, dass bei noch nicht montiertem Kabelbaumstecker 51 die beiden Kontaktträger 53, 54 bzw. die Gegenelemente 60 derart zueinander angeordnet bzw. positioniert sind, dass ein zwischen den Kontaktträgern 53, 54 ausgebildeter, in der Fig. 4 erkennbarer Zwischenraum 61 derart bemessen ist, dass die Leiterplatte 18 mit ihren Kontaktabschnitten 22 in den Zwischenraum 61 eingeführt werden kann, ohne zunächst in Wirkverbindung mit den Gegenelementen 60 zu geraten.

Bei der Montage des Kabelbaumsteckers 51 an dem Anbauelement 11 wird der Kabelbaumstecker 51 entsprechend der Fig. 5 in Richtung des Pfeils 62 mit dem Anbauelement 11 verbunden. Hierbei gelangen die beiden Kontaktträger 53, 54, von denen in den Fig. 5 und 6 der Einfachheit halber lediglich der eine, obere Kontaktträger 53 dargestellt bzw. erkennbar ist, in den Bereich ober- bzw. unterhalb der Leiterplatte 18 und der Kontakteinheiten 22, ohne diese zunächst zu berühren. Erst kurz bevor entsprechend der Fig. 6 die Rastverbindung zwischen dem Anbauelement 11 und dem Halteelement 55 ausgebildet ist, gelangen die im Anbauelement 11 angeordneten Federelemente 27 in Wirkverbindung mit den Oberseiten der beiden Kontaktträgern 53, 54 auf der den Gegenelementen 60 abgewandten Seite und drücken diese elastisch mittels der Andrückkraft F in Richtung der Leiterplatte 18 bzw. der Kontakteinheiten 22, sodass über die Kontaktträger 53, 54 auf die Gegenelemente 60 eine Anlagekraft ausgeübt wird, die die Gegenelemente 60 gegen die Kontaktabschnitte 22 drückt, um eine sichere elektrische Verbindung auszubilden.

Das soweit beschriebene Steuergerät 10 bzw. die Baueinheit 50 können in vielfältiger Art und Weise abgewandelt bzw. modifiziert werden, ohne vom Erfindungsgedanken abzuweichen.

## Patentansprüche

1. Steuergerät (10), mit einer Gehäuseeinheit (12), die aus einer aus Kunststoff bestehenden Schutzmasse (20) besteht und die einen Schaltungsträger (18) zumindest bereichsweise unmittelbar umgibt, mit wenigstens einer auf dem Schaltungsträger (18) angeordneten Schaltungseinheit und mit mindestens einer Kontakteinheit (22) für eine elektrische Kontaktierung des Steuergeräts (10) mit einer anderen elektrischen Baueinheit (50), wobei die Gehäuseeinheit (12) im Bereich der Kontakteinheit (22) zumindest bereichsweise frei von der Schutzmasse (20) ist,
**dadurch gekennzeichnet,**
**dass** mit der Gehäuseeinheit (12) wenigstens ein Anpresselement (26) verbunden ist, das dazu ausgebildet ist, zumindest mittelbar eine Andrückkraft (F) auf ein die Kontakteinheit (22) elektrisch kontaktierendes Gegenelement (60) der anderen elektrischen Baueinheit (50) zu erzeugen.

2. Steuergerät nach Anspruch 1,
**dadurch gekennzeichnet,**
**dass** das wenigstens eine Anpresselement (26) in einem mit der Gehäuseeinheit (12) verbundenen Anbauelement (11) angeordnet ist.

3. Steuergerät nach Anspruch 2,
**dadurch gekennzeichnet,**
**dass** das Anbauelement (11) den Schaltungsträger (18) zumindest im Bereich der Kontakteinheit (22) umgibt.

4. Steuergerät nach Anspruch 2 oder 3,
**dadurch gekennzeichnet,**
**dass** das Anbauelement (11) aus Kunststoff besteht und im Wesentlichen eine hülsenförmige Form aufweist, die auf der der Gehäuseeinheit (12) abgewandten Stirnseite eine Öffnung (58) zum Einführen des Gegenelements (60) der anderen elektrischen Baueinheit (50) hat, und dass im Bereich der Öffnung (58) vorzugsweise ein der Versteifung des Anbauelements (11) dienender Steg (68) angeordnet ist.

5. Steuergerät nach einem der Ansprüche 2 bis 4,
**dadurch gekennzeichnet,**
**dass** das Anbauelement (11) mit der Gehäuseeinheit (12) mittels einer Rastverbindung (16) verbunden ist.

6. Steuergerät nach einem der Ansprüche 2 bis 5,
**dadurch gekennzeichnet,**
**dass** das Anpresselement (26) als ein aus Metall bestehendes Federelement (27) ausgebildet ist, das vorzugsweise durch eine kraftschlüssige Verbindung mit dem Anbauelement (11) verbunden ist.

7. Steuergerät nach Anspruch 6,
**dadurch gekennzeichnet,**
**dass** das Federelement (27) mehrere Federabschnitte (28, 29) aufweist, und dass die Federabschnitte (28, 29) mittels eines Verbindungsabschnitts (30) miteinander verbunden sind, wobei der Verbindungsabschnitt (30) einen umgebogenen Versteifungsabschnitt (32) aufweist, der in Richtung zu den Federabschnitten (28, 29) umgebogen ist.

8. Steuergerät nach Anspruch 7,
**dadurch gekennzeichnet,**
**dass** der Federabschnitt (28, 29) einen Anlagebereich (40) aufweist, der dazu ausgebildet ist, mit dem Gegenelement (60) der anderen elektrischen Baueinheit (50) zumindest mittelbar zusammenzuwirken, und dass der Anlagebereich (40) in Überdeckung und beabstandet zur Kontakteinheit (22) angeordnet ist.

9. Steuergerät nach einem der Ansprüche 2 bis 8,
**dadurch gekennzeichnet,**
**dass** zwischen dem Anbauelement (11) und der Gehäuseeinheit (12) wenigstens ein Dichtungselement (25) angeordnet ist.

10. Anordnung, bestehend aus einem Steuergerät (10) nach einem der Ansprüche 1 bis 9 und einer elektrischen Baueinheit (50), die dazu ausgebildet ist, mit dem Steuergerät (10) verbunden zu werden, **dadurch gekennzeichnet,**
**dass** die Baueinheit (50) wenigstens einen vorzugsweise plattenförmigen Kontaktträger (53, 54) aufweist, der für jede Kontakteinheit (22) des Steuergeräts (10) ein Gegenelement (60) aufweist.

11. Anordnung nach Anspruch 10,
**dadurch gekennzeichnet,**
**dass** der Kontaktträger (53, 54) in der Baueinheit (50) elastisch verformbar angeordnet ist und von dem Andrückelement (26) auf der dem Gegenelement (60) abgewandten Seite, die Andrückkraft (F) auf das Gegenelement (60) bildend, in Richtung zur Kontakteinheit (22) bewegbar.

12. Anordnung nach Anspruch 10 oder 11,
**dadurch gekennzeichnet,**
**dass** der Kontaktträger (53, 54), vorzugsweise unter Zwischenlage eines Dichtelements (56) mit einem Halteelement (55) verbunden ist, wobei das Halteelement (55) dazu ausgebildet ist, mit dem Steuergerät (10) verbunden zu werden.

13. Anordnung nach Anspruch 12,
**dadurch gekennzeichnet,**
**dass** der Kontaktträger (53, 54) auf der dem Steuergerät (10) zugewandten Seite aus dem Halteelement (55) herausragt, und dass das Halteelement (55) einen Gehäuseabschnitt (65) aufweist, der dazu ausgebildet ist, das Steuergerät (10) im Bereich des Anbauelements (11) zumindest mittelbar zu umfassen.

14. Anordnung nach einem der Ansprüche 10 bis 13,
**dadurch gekennzeichnet,**
**dass** die Baueinheit (50) ein Kabelbaumstecker (51) ist.

15. Verwendung einer Anordnung nach einem der Ansprüche 10 bis 14 in Kraftfah rzeugen.

## Claims

1. Controller (10), comprising a housing unit (12) which consists of a protective mass (20), which is composed of plastic, and at least in regions directly surrounds a circuit carrier (18), comprising at least one circuit unit which is arranged on the circuit carrier (18), and comprising at least one contact unit (22) for electrical contact-connection of the controller (10) with another electrical structural unit (50), wherein the housing unit (12) is free of the protective mass (20) in the region of the contact unit (22) at least in regions,
**characterized**
**in that** at least one pressing element (26) is connected to the housing unit (12), which pressing element is designed to at least indirectly generate a contact-pressure force (F) onto a mating element (60) of the other electrical structural unit (50), which mating element makes electrical contact with the contact unit (22) .

2. Controller according to Claim 1,
**characterized**
**in that** the at least one pressing element (26) is arranged in an attachment element (11) which is connected to the housing unit (12).

3. Controller according to Claim 2,
**characterized**
**in that** the attachment element (11) surrounds the circuit carrier (18) at least in the region of the contact unit (22) .

4. Controller according to Claim 2 or 3,
**characterized**
**in that** the attachment element (11) consists of plastic and substantially has a sleeve-like shape which, on that end side which is averted from the housing unit (12), has an opening (58) for inserting the mating element (60) of the other electrical structural unit (50), and in that a web (68) which serves to reinforce the attachment element (11) is preferably arranged in the region of the opening (58).

5. Controller according to one of Claims 2 to 4,
**characterized**
**in that** the attachment element (11) is connected to the housing unit (12) by means of a latching connection (16) .

6. Controller according to one of Claims 2 to 5,
**characterized**
**in that** the pressing element (26) is designed as a spring element (27) which consists of metal and is preferably connected to the attachment element (11) by a force-fitting connection.

7. Controller according to Claim 6,
**characterized**
**in that** the spring element (27) has a plurality of spring sections (28, 29), and in that the spring sections (28, 29) are connected to one another by means of a connecting section (30), wherein the connecting section (30) has a bent-over reinforcing section (32) which is bent over in the direction of the spring sections (28, 29).

8. Controller according to Claim 7,
**characterized**
**in that** the spring section (28, 29) has an abutment region (40) which is designed to at least indirectly interact with the mating element (60) of the other electrical structural unit (50), and in that the abutment region (40) is arranged so as to overlap with and at a distance from the contact unit (22).

9. Controller according to one of Claims 2 to 8,
**characterized**
**in that** at least one seal element (25) is arranged between the attachment element (11) and the housing unit (12).

10. Arrangement consisting of a controller (10) according to one of Claims 1 to 9 and an electrical structural unit (50) which is designed to be connected to the controller (10),
**characterized**
**in that** the structural unit (50) has at least one preferably plate-like contact carrier (53, 54) which has a mating element (60) for each contact unit (22) of the controller (10).

11. Arrangement according to Claim 10,
**characterized**
**in that** the contact carrier (53, 54) is arranged in an elastically deformable manner in the structural unit (50) and can be moved by the contact-pressure element (26) on that side which is averted from the mating element (60) in the direction of the contact unit (22), so as to form the contact-pressure force (F) onto the mating element (60) .

12. Arrangement according to Claim 10 or 11,
**characterized**
**in that** the contact carrier (53, 54) is connected to a holding element (55), preferably with the interposition of a sealing element (56), wherein the holding element (55) is designed to be connected to the controller (10).

13. Arrangement according to Claim 12,
**characterized**
**in that** the contact carrier (53, 54) protrudes out of the holding element (55) on that side which faces the controller (10), and in that the holding element (55) has a housing section (65) which is designed to at least indirectly comprise the controller (10) in the region of the attachment element (11).

14. Arrangement according to one of Claims 10 to 13,
**characterized**
**in that** the structural unit (50) is a cable harness plug (51) .

15. Use of an arrangement according to one of Claims 10 to 14 in motor vehicles.

## Revendications

1. Appareil de commande (10) comprenant une unité de boîtier (12) qui se compose d'une masse de protection (20) constituée de plastique et qui entoure au moins en partie directement un support de circuit (18), comprenant au moins une unité de circuit disposée sur le support de circuit (18) et au moins une unité de contact (22) pour un contact électrique de l'appareil de commande (10) avec une autre unité modulaire électrique (50), l'unité de boîtier (12), dans la région de l'unité de contact (22), étant au moins en partie exempte de la masse de protection (20),
**caractérisé en ce**
**qu'**au moins un élément de pressage (26) est connecté à l'unité de boîtier (12), lequel est réalisé pour générer au moins indirectement une force de pressage (F) sur un élément conjugué (60) de l'autre unité modulaire électrique (50), venant en contact électriquement avec l'unité de contact (22).

2. Appareil de commande selon la revendication 1,
**caractérisé en ce que**
l'au moins un élément de pressage (6) est disposé dans un élément de montage (11) connecté à l'unité de boîtier (12).

3. Appareil de commande selon la revendication 2,
**caractérisé en ce que**
l'élément de montage (11) entoure le support de circuit (18) au moins dans la région de l'unité de contact (22).

4. Appareil de commande selon la revendication 2 ou 3,
**caractérisé en ce que**
l'élément de montage (11) se compose de plastique et présente essentiellement une forme en forme de douille, qui présente, sur le côté frontal opposé à l'unité de boîtier (12), une ouverture (58) pour l'introduction de l'élément conjugué (60) de l'autre unité modulaire électrique (50), et **en ce que** dans la région de l'ouverture (58) est disposée de préférence une nervure (68) servant à renforcer l'élément de montage (11).

5. Appareil de commande selon l'une quelconque des revendications 2 à 4,
**caractérisé en ce que**
l'élément de montage (11) est connecté à l'unité de boîtier (12) au moyen d'une connexion par encliquetage (16).

6. Appareil de commande selon l'une quelconque des revendications 2 à 5,
**caractérisé en ce que**
l'élément de pressage (26) est réalisé sous forme d'élément de ressort (27) constitué de métal, qui est connecté de préférence par une connexion par engagement par force à l'élément de montage (11).

7. Appareil de commande selon la revendication 6,
**caractérisé en ce que**
l'élément de ressort (27) présente plusieurs portions de ressort (28, 29), et **en ce que** les portions de ressort (28, 29) sont connectées les unes aux autres au moyen d'une portion de connexion (30), la portion de connexion (30) présentant une portion de renforcement recourbée (32) qui est recourbée dans la direction des portions de ressort (28, 29).

8. Appareil de commande selon la revendication 7,
**caractérisé en ce que**
la portion de ressort (28, 29) présente une région d'appui (40) qui est réalisée pour coopérer au moins indirectement avec l'élément conjugué (60) de l'autre unité modulaire électrique (50), et **en ce que** la région d'appui (40) est disposée de manière à recouvrir, à distance, l'unité de contact (22).

9. Appareil de commande selon l'une quelconque des revendications 2 à 8,
**caractérisé en ce**
**qu'**au moins un élément d'étanchéité (25) est disposé entre l'élément de montage (11) et l'unité de boîtier (12).

10. Agencement constitué d'un appareil de commande (10) selon l'une quelconque des revendications 1 à 9 et d'une unité modulaire électrique (50) qui est réalisée pour être connectée à l'appareil de commande (10),
**caractérisé en ce que**
l'unité modulaire (50) présente au moins un support de contact de préférence en forme de plaque (53, 54) qui présente, pour chaque unité de contact (22) de l'appareil de commande (10), un élément conjugué (60).

11. Agencement selon la revendication 10,
**caractérisé en ce que**
le support de contact (53, 54) est disposé de manière élastiquement déformable dans l'unité modulaire (50) et peut être déplacé dans la direction de l'unité de contact (22) par l'élément de pression (26) du côté opposé à l'élément conjugué (60), en formant la force de pressage (F) sur l'élément conjugué (60).

12. Agencement selon la revendication 10 ou 11,
**caractérisé en ce que**
le support de contact (53, 54) est connecté, de préférence par interposition d'un élément d'étanchéité (56), à un élément de retenue (55), l'élément de retenue (55) étant réalisé de manière à être connecté à l'appareil de commande (10).

13. Agencement selon la revendication 12,
**caractérisé en ce que**
le support de contact (53, 54) fait saillie du côté tourné vers l'appareil de commande (10) hors de l'élément de retenue (55), et **en ce que** l'élément de retenue (55) présente une portion de boîtier (65) qui est réalisée de manière à entourer au moins indirectement l'appareil de commande (10) dans la région de l'élément de montage (11).

14. Agencement selon l'une quelconque des revendications 10 à 13,
**caractérisé en ce que**
l'unité modulaire (50) est un connecteur de faisceau de câbles (51).

15. Utilisation d'un agencement selon l'une quelconque des revendications 10 à 14 dans des véhicules automobiles.
